# EUROPEAN PATENT SPECIFICATION

(11) **EP 0 800 457 B1**
(45) Date of publication and mention of the grant of the patent: **05.07.2000**
(21) Application number: 95941223.0
(22) Date of filing: 21.12.1995
(51) Int. Cl.: B41F 15/42, H05K 3/12

(54) **METHOD AND APPARATUS FOR DISPENSING VISCOUS MATERIAL**
VERFAHREN UND VORRICHTUNG ZUM ABGEBEN EINES VISKOSEN MATERIALS
PROCEDE ET APPAREIL DE DISTRIBUTION D'UN MATERIAU VISQUEUX

(30) Priority: 27.12.1994 US 363806
(43) Date of publication of application: 15.10.1997
(73) Proprietor: Ford Motor Company, Dearborn, MI 48126 (US); FORD MOTOR COMPANY LIMITED, Brentwood, Essex CM13 3BW (GB)
(72) Inventor: HA, Vinh, Van, Southfield, MI 48076 (US); LIN, Jeff, Canton, MI 48188 (US); NATION, Brenda, Joyce, Troy, MI 48098 (US); TRUBLOWSKI, John, Troy, MI 48083 (US); PERNG, Chin-Yuan, Ann Arbor, MI 48105 (US)
(74) Representative: Messulam, Alec Moses
(86) International application number: PCT/GB95/03002
(87) International publication number: WO 96/20088

(56) References cited:
- EP-A- 0 504 501
- US-A- 4 023 486
- US-A- 4 622 239
- US-A- 4 636 406
- US-A- 4 720 402
- US-A- 5 309 837
- PATENT ABSTRACTS OF JAPAN vol. 13 no. 434 (M-875) ,28 September 1989 & JP,A,01 166961 (MATSUSHITA ELECTRIC IND CO) 30 June 1989,
- PATENT ABSTRACTS OF JAPAN vol. 16 no. 434 (M-1308) ,10 September 1992 & JP,A,04 147860 (MATSUSHITA ELECTRIC IND CO) 21 May 1992,

## Description

### Field of the Invention

The present invention relates to methods and devices for depositing viscous materials onto a printed wiring board and to methods and devices for compressing viscous materials, such as solder paste, through openings in a perforated substrate, such as a patterned screen or stencil.

### Description of Related Art

Surface Mount Technology (SMT) involves placing circuit components onto circuit paths embedded on the upper surface of a printed wiring board and then soldering the components in place by a process called "reflow soldering". Before the circuit component is placed on the printed wiring board, however, it is desirable to apply solder paste to the area on the printed wiring board where the component is to be soldered into place.

Conventional methods do exist to deposit ("print") solder paste onto desired areas of a printed wiring board by forcing the paste through openings in a substrate (e.g., a stencil) placed in intimate contact with the printed wiring board.

U.S. Patent No. 4,622,239 describes such a method and device for dispensing viscous materials. The method includes forcing a viscous material from a housing through an opening and depositing it onto a stencil between a pair of flexible members (parallel squeegee blades) which depend from the housing on either side of the opening and are in contact with the stencil. The ends of the flexible members are not connected and remain open ended. The viscous material, accordingly, is not contained within an enclosed area when it is deposited on the surface of the stencil. Movement of the housing and the flexible members horizontally across the stencil causes the trailing flexible member to force the viscous material through the openings in the stencil.

U.S. Patent No. 4,720,402 describes a similar method and device except that the leading flexible member is raised off of the stencil during movement of the housing.

U.S. Patent Nos. 5,133,120 and 5,191,709 describe methods for filling through-holes of a printed wiring board via a mask with pressurised conductive filler material by means of a nozzle assembly unit having a nozzle tip member. The nozzle tip member, however, is designed only to dispense the pressurised conductive filler material through the mask to a single through-hole. The nozzle tip member then "scans" the printed wiring board for a second through-hole to fill. The nozzle tip member has a blunt end section which rests on the mask and a circular exit, the diameter of which may be increased or decreased by changing the nozzle tip member. The nozzle tip member dispenses the filler material without controlling unwanted flow of "excessive" filler material back through the stencil. Additionally, the nozzle tip member does not define a contained environment where "compression" of the filler material takes place through the mask followed by the immediate shearing off of the filler material within that contained environment from the surface of the stencil. In fact, the nozzle tip member itself provides no effective means for shearing off filler material from the top of the stencil, rather, after the through hole is filled and filler material "backs up" through the stencil, the nozzle tip member moves forward whereupon the "excessive" filler material is then wiped off by a separate, single, flexible squeegee member which is designed for unidirectional use only.

Unfortunately, these conventional efforts do not provide a contained environment for compression of viscous material through holes in a stencil and shearing of viscous material within the contained environment from the upper surface of the stencil. Reliance upon squeegee movement to force the viscous material, such as solder paste, through the stencil openings can lead to damage and eventual failure of both the squeegee blades and the stencil due to repeated friction. Since conventional efforts do not provide a contained environment in which compression and shearing is accomplished, waste of the viscous material is frequently encountered.

The above prior art proposals therefore fail to maximise the efficiency of printing solder paste onto a desired area of a printed wiring board and fail to minimise waste of the solder paste during the printing process.

U.S. Patent 5,345,867 describes generally parallel, offset "doctor blades" for stripping off ink from the ink roller of a web-fed rotary printing press. The doctor blades 9,8 are each biased into the ink roller 2 by suitable springs 54,53 that are contained within channels 49,48, respectively. These springs function to "resiliently urge the outer ends of the blades 9 and 8 into engagement with the screened ink roller 2 at a negative contact angle" in order to assure that the blades will not be deformed or bent and that proper contact with the ink roller will be maintained. However, these blades cannot be adapted for the application of a viscous material and would not function to relieve pressure as the printhead rides unevenly across the substrate.

USP 4,622,239 is concerned with an apparatus for dispensing solder paste into openings in a stencil and comprises a housing having a piston slidably mounted therein. A manifold having a successively increasing cross-sectional area, is attached to a side wall of the housing for admitting a viscous material, such as solder paste therein through successively larger sized openings so the paste is distributed evenly beneath the piston. A pair of elastomeric blades are secured to, and depend from the housing on opposite sides of a slot to contact the stencil. Upon the application of a fluid pressure against the piston, paste will be expelled from the slot within a working region between the blades. The blades force paste into the openings in the stencil when the housing is moved thereacross. In order to ensure that this occurs, the lower edge of each blade is maintained in contact with the stencil by arranging the housing at a predetermined height above the stencil.

USP 4,023,486 describes a squeegee apparatus for rotary screen printing of carpets and other materials. A reservoir for receiving printing liquid is supported in spaced apart relation with a printing screen having a perforated pattern design therein. A squeegee head having screen-contacting, low coefficient of friction material, sealing members is suspended from the reservoir with a flexible interconnection allowing the sealing members to ride over the screen surface as the screen and squeegee head undergo relative movement during printing. The sealing members are attached to the squeegee head by means of resilient mounting members which are bent downwardly to urge the sealing members in contact with the printing screen.

The present invention is concerned with keeping the full length of the edge of the wiper or squeegee blades parallel with the stencil as the printhead travels at high speed, when the hydrodynamic pressure induced by the rolling action of the viscous material ahead of the leading edge wiper blade causes it to lift up from the surface of the stencil (much like the hydroplaning in an automobile tire tracking over a fluid covering the driving surface). Conventional solutions to this problem such as central pivot floatation of the wiper blades results in uneven pressures along the length of the wiper blades during printing, and thus uneven and possibly defective print transfer of the viscous material within the apertures in the stencil.

### Summary of the invention

According to the invention, there is provided an apparatus as disclosed in claim 1 hereafter.

During operation of the apparatus, two generally parallel wiper blades forming the compression headcap are biased into sliding communication with a stencil having a plurality of openings therein. The compression headcap and the stencil form a contained environment. The pressure source then applies pressure against the viscous material contained in the reservoir forcing it from the reservoir into the housing and to the compression headcap. The contiguous walls of the compression headcap act to contain and to direct flow of the pressurised viscous material to the top surface of the stencil and then through the openings in the stencil. The biasing force against the wiper blades keeps them in sliding communication with the stencil, even when downward pressure induced on the viscous material being sheared off by the leading edge of the wiper blade tends to lift the compression headcap up and away from the stencil.

### Brief description of the drawings

The invention will now be described further, by way of example, with reference to the accompanying drawings, in which:
Figure 1 is a perspective view of an apparatus of the present invention, partially exploded,
Figure 2 is a side cross-sectional view of a compression head, a compression headcap, a stencil and a printed wiring board showing movement of the solder paste through the compression head, the compression headcap and the openings of the stencil onto the printed wiring board,
Figure 3 is a bottom perspective view of the compression headcap, partially broken away,
Figure 4 is an exploded perspective view of the compression head showing components of the compression headcap and one embodiment of a diffuser,
Figure 5 is an exploded perspective view of the compression head showing components of the compression headcap and a second embodiment of a diffuser,
Figure 6 is a partially exploded perspective view of a second embodiment of the compression headcap that includes a pair of self-levelling squeegee blades,
Figure 7 is a front view of the compression head shown in Figure 6 illustrating the location of the leaf springs,
Figure 8 is a top perspective view of the self-levelling squeegee blades taken along section lines 8-8 in Figure 7,
Figure 9 is a side cross-sectional view of a second embodiment of the compression head, the compression headcap, a stencil and a printed wiring board showing movement of the solder paste through the compression head, the compression headcap and the opening of the stencil onto the printed wiring board,
Figure 10 is a bottom perspective view of the second embodiment of the compression head illustrating the location of the leaf springs and the integral end caps attached to the self-levelling blades,
Figure 11 is a bottom perspective exploded view illustrating the integral, overlapping end caps attached to the ends of the self-level squeegee blades, and
Figure 12 is an exploded perspective view of the second embodiment of the compression head, including a third embodiment of the diffuser plates having a vertical channel orientation.

### Detailed description of the preferred embodiments

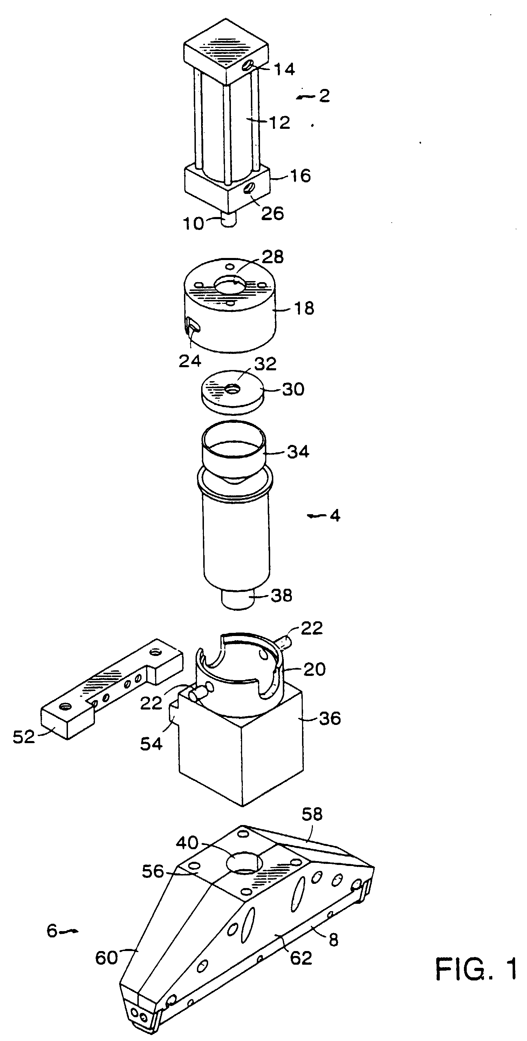

The principles of the present invention may be applied with particular advantage to obtain an apparatus for compressing a viscous material through openings in a stencil, preferred embodiments of which may be seen at Figs. 1, 2, 3, 4, and 5 which are described more fully below.

Figure 1 is a partially exploded perspective view of one embodiment of an apparatus of the present invention. As can be generally seen at Figure 1, the apparatus has a pressure source 2 which is operably connected to a reservoir 4 containing a supply of a viscous material, a compression head 6 and a compression headcap 8.

More particularly, Figure 1 shows a pressure source depicted as an air cylinder 2 having a piston (not shown) connected to a rod 10 contained in a cylinder housing 12. Pressure inlet 14 allows for the introduction of air pressure at the top of air cylinder 2 thereby displacing the piston causing piston rod 10 to move downward. The air cylinder 2 is mounted via base 16 to cylinder mount 18 which in turn is removably mounted to casing 20 via a twist socket connector having posts 22 and socket grooves, one of which is shown at 24. Base 16 has air inlet 26 for the introduction of air pressure at the bottom of air cylinder 2 thereby displacing the piston causing piston rod 10 to move upward.

Piston rod 10 extends through opening 28 of cylinder mount 18 and is fixedly connected to syringe pusher 30 at contact 32 which in turn engages displacement piece 34 which is movably disposed within syringe 4 which contains a viscous material. Displacement piece 34 acts as a plunger and is designed to mate with the interior of syringe 4 to ensure effective displacement of viscous material with minimal waste. Pressure source 2 is designed to mechanically meter out viscous material through operation of the syringe pusher 30 on the displacement piece 34. The syringe pusher 30, displacement piece 34 and syringe 4 are all vertically housed in operative fashion within the cylinder mount 18, the casing 20 and the syringe housing 36.

The vertical arrangement of the pressure source 2 and the syringe 4 containing the viscous material is a preferred arrangement which advantageously provides for even and direct pressure in metering out the viscous material onto the top surface of a stencil. It is to be understood that pressure source 2 is not limited to an air cylinder of the type depicted in Figure 1, but that other suitable pressure sources may be used by one of ordinary skill in the art. Such pressure sources include those which mechanically, electrically, or hydraulically operate a mechanical force, such as a piston rod and displacement piece, to meter out viscous material from a syringe housing or other reservoir which contains viscous material. In addition, pneumatic pressure may be used directly to force viscous material from a reservoir housing. Also, pressure source and reservoir configurations other than the vertical configuration depicted in Figure 1 may be used in the present invention. Such configurations include side mounted reservoirs and pressure sources or other configurations readily known to those skilled in the art.

The syringe 4 is preferably a disposable unit which can be replaced when desired by disconnecting cylinder mount 18 from casing 20 via the twist socket connector, removing the syringe and replacing it with an alternative syringe. Examples of disposable syringes that may be used include those which are readily commercially available from Methods Engineering, Vauxhall, New Jersey. The cartridges may be purchased prefilled with suitable viscous materials or they may be purchased empty and then filled with suitable viscous materials, such as solder pastes. Suitable solder pastes may be readily commercially available from Alpha Metals, Jersey City, New Jersey.

Typical solder pastes useful with surface mount technology generally contain an alloy of tin, lead and silver in various proportions in combination with other useful solder paste metals, viscosity agents, flux and/or solvents depending upon the desired use of the solder paste. Suitable solder pastes will become apparent to one of ordinary skill in the art based upon the teachings herein.

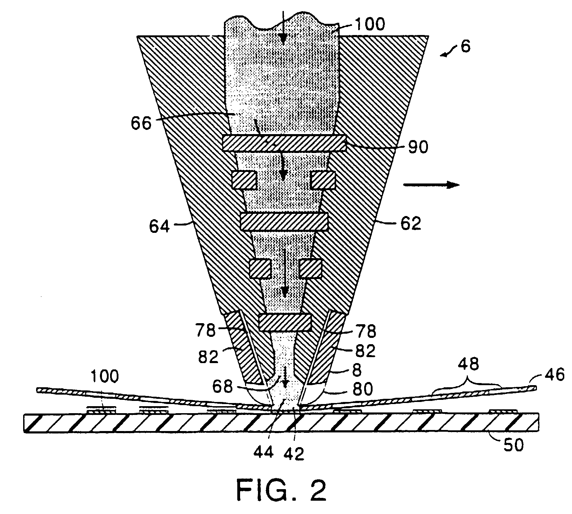

The syringe housing 36 is mounted to a housing referred to herein as a compression head generally depicted at 6 in Figure 1 and shown in a cross-sectional side view in Figure 2. The syringe 4 has flange opening 38 which is inserted into and mates with first opening 40 of compression head 6 which is described hereafter with reference to both Figs. 1 and 2 and Figure 3 which is a bottom perspective view of the compression headcap 8, partially broken away. The compression head 6 terminates in a substantially uniform second opening 42 which is defined by compression headcap 8. The compression headcap 8 is formed from contiguous walls which define a volume 44 within compression headcap 8. The contiguous walls may be either unitary or formed from separate elements and are designed to contact stencil 46 to provide a uniform and substantially flush union with stencil 46 at the point of contact. As can be seen in Figure 2, stencil 46 has openings 48 and is placed in an operable relationship with a printed wiring board 50. The stencil 46 may be placed in intimate contact with printed wiring board 50 or, as shown in Figure 2, it may be placed a distance above printed wiring board 50 such that pressure from the compression head 6 forces the stencil 46 into contact with printed wiring board 50. Although stencil 46 is shown in cross-section, it is to be understood that openings 48 may have any desired orientation on stencil 46. Further openings 48 may differ in size depending upon the area of the printed wiring board 50 to be printed with the viscous material. The compression headcap 8 and stencil 46 together form a contained environment 44 for the viscous material during operation of the apparatus.

As can be seen in Figure 1, cross bar mount 52 is attached to syringe housing 36 via flange 54. Cross bar mount 52 is also attached to a mechanism (not shown) for horizontally displacing the apparatus along the stencil 46.

The compression head 6 is preferably formed from metal, such as iron or stainless steel or other material suitable for use with pressurised viscous material. The compression head 6 has top surface 56 which serves as the base to which the syringe housing 36 is attached. Side surfaces 58 and 60 extending from top surface 56 slope away from each other as depicted in Figure 1 to define an increasing length of compression head 6. Front and back surfaces 62 and 64 are contiguous with side surfaces 58 and 60 and slope toward each other as depicted in Figure 2 to define a decreasing width of compression head 6. The side surfaces join with the front and back surfaces to define a tapered interior chamber 66 as shown in Figure 2 which acts to restrict flow of viscous material through compression head 6. Interior chamber 66 terminates in generally rectangular exit 68. Compression head 6 preferably acts as a nozzle to direct and constrict the flow of viscous material through generally rectangular exit 68. The compression headcap 6 defines a volume 44 surrounding the rectangular exit 68 and into which viscous material flows after exiting the interior chamber 66 of compression head 6. As shown in Figure 2, the volume 44 is preferably a separate chamber into which the viscous material flows after exiting the interior chamber 66 via rectangular exit 68. The compression headcap 8 defines a generally rectangular opening 42 which is to be contacted with stencil 48. The compression headcap 8 acts to contain and direct the flow of viscous material to the stencil 46. In an alternative embodiment, it is to be understood that the interior chamber 66 may terminate directly into compression headcap 8 without the need for rectangular exit 68 or volume 44.

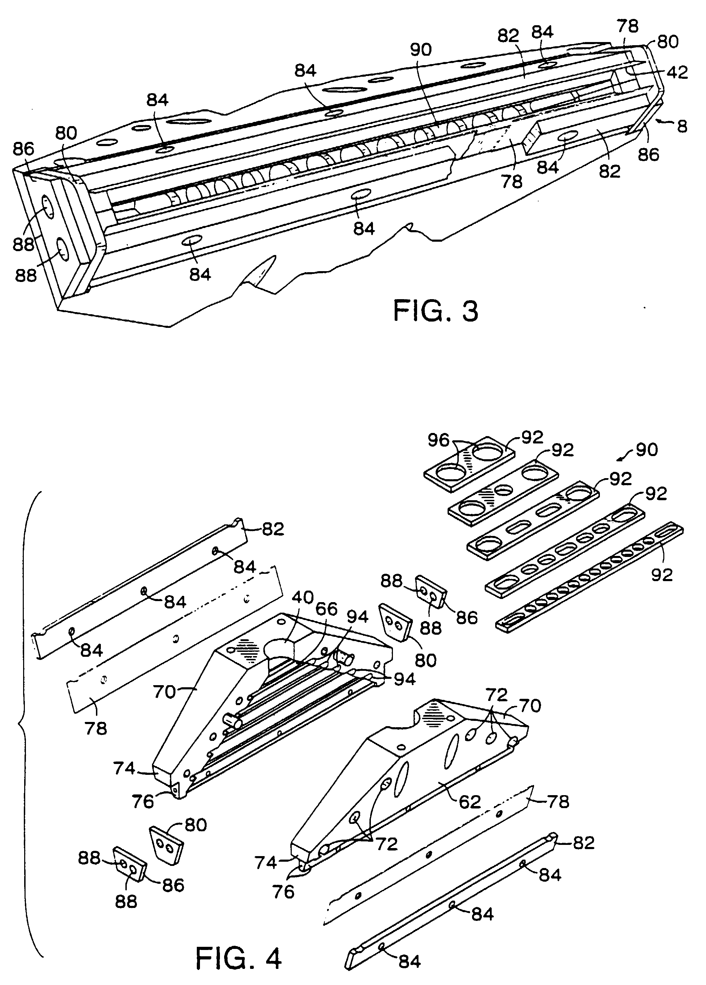

As can be seen in Figure 4, the compression head 6 has two half sections 70 which are fixedly connected by screws (not shown) via screw holes 72. The bottom side section 74 of each half section 70 is provided with ledge area 76 to engage the compression headcap 8. As depicted in Figs. 2, 3 and 4, compression headcap 8 has rectangular blades 78 and end caps 80, which define generally rectangular opening 42. Blades 78 are each fixedly mounted to a corresponding ledge area 76 of front surface 62 and back surface 64, respectively, by means of corresponding rectangular blade holders 82 and screws (not shown) via screw holes 84. Blades 78 each extend along substantially the entire length of corresponding ledge area 76. End caps 80 are attached to a corresponding ledge area 76 of bottom side section 74 via corresponding cap mounts 86 and screws (not shown) via screw holes 88. The end caps 80 are contiguous with blades 78 and together form the compression headcap 8. As can be seen more clearly in Figure 2, blades 78 parallel the slope of corresponding front and back surfaces 62 and 64, and are, therefore, seen to be angled inward relative to the interior chamber 66 of compression head 8.

Blades 78 are preferably thin and formed from rigid material such as iron or stainless steel. End caps 80 are preferably formed from a flexible substance such as polyurethane to avoid damage to the stencil during operation of the apparatus. Cap mounts 86 and blade holders 82 are formed from any solid material capable of securing the corresponding end cap or blade.

While the compression headcap 8 is depicted in Figs. 2, 3, and 4 as being formed from integral parts, it is to be understood that compression headcaps having a unitary structure are within the teachings of the present invention. Such unitary compression headcaps are formed from a single rectangular shaped unit and are designed to encircle the ledge area 76 of the compression head 6 or otherwise operatively engage compression head 6. Such compression headcaps may be either fixed or removably mounted to the compression head and may have various sizes of opening 42.

The compression head 6 and compression headcap 8, in combination with the pressure source 2 and syringe 4 advantageously provide a vertical down force to move the viscous material evenly and directly to the stencil. The compression headcap 8 of advantageously provides a contained environment to direct and to aid in the extruding of pressurised viscous material through openings in the stencil. The extruded viscous material is then deposited on the pattern of the printed wiring board. The apparatus provides for very high speed printing capability while maintaining print definition and reduced cycle time. Waste of viscous material is minimised due to the contained environment provided by the compression headcap 8. The length of the compression headcap 8 allows for simultaneous compression printing through a plurality of openings 48 in stencil 46. Furthermore, the trailing blade 78 relative to the direction of operation advantageously operates to shear off the viscous material contacting the stencil within the compression headcap 8 when the apparatus is horizontally disposed across the stencil. The blades 78 are rigid and angled to advantageously achieve a smooth shearing of the viscous material. The compression head 6 and compression headcap 8 are advantageously rectangular in shape so that they may operate over a significant area of the stencil with each pass. Additionally, given the dual blade design of the compression headcap 8, the apparatus may operate in both the forward and reverse directions thereby improving the efficiency of the compression printing process.

As can be further seen in Figs. 2 and 4, compression head 6 has diffuser 90 which is fixedly mounted within interior chamber 66. Diffuser 90 has a plurality of diffuser plates 92 which are horizontally disposed within interior chamber 66 via grooves 94. Each diffuser plate 92 has a series of openings 96 through which viscous material is to flow. Each opening 96 may be either circular or oblong and decreases in average size as the diffuser plates progress from the first opening 40 to the compression headcap 8. The openings 96 also increase in number as the diffuser plates progress from the first opening 40 to the compression headcap 8. The diffuser 90 advantageously serves to break up the flow of viscous material and evenly and uniformly distribute it from side to side of the rectangular exit 42. The diffuser 90 may also serve to reduce the velocity of the viscous material flowing through the compression head and increase the static pressure of the viscous material which aids in the compression printing process.

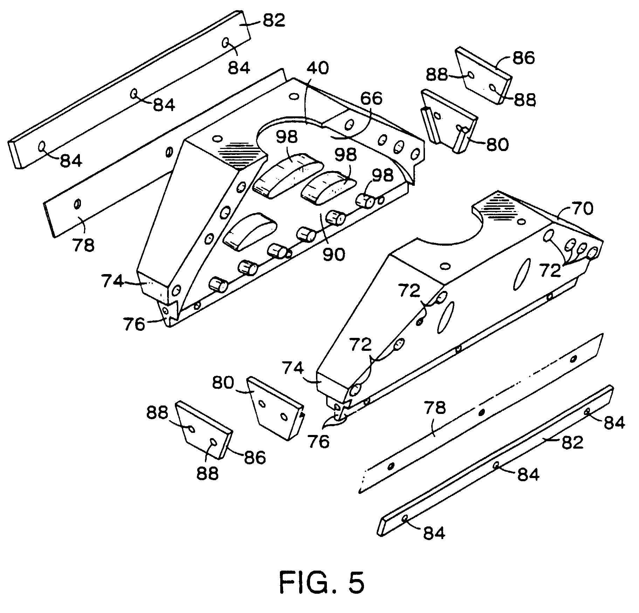

Figure 5 shows an alternative embodiment of a diffuser 90 that may be used. The diffuser 90 has a plurality of diffuser islands 98 which are horizontally disposed in rows within interior chamber 66. The diffuser islands 98 may be fixedly installed within the interior chamber 66 or they may be moulded directly within the interior chamber 66. As with the diffuser 90 of Figure 4, each diffuser island 98 acts to break up the flow of the viscous material and uniformly and evenly distribute it from side to side of rectangular exit 42. The diffuser islands may be either circular or oblong and decrease in average size as the rows progress from the first opening 40 to the compression headcap 8. The diffuser islands 98 also increase in number as the rows progress from the first opening 40 to the compression headcap 8. The diffuser islands 98 are advantageous in that they provide for ease of fabrication of the compression head and ease of cleaning.

Operation of the apparatus will now described with reference to Figs. 1 and 2. When compression printing, the compression headcap 8 of the apparatus is brought into contact with the top surface of stencil 46 which forces the stencil downward until it is in intimate contact with the printed wiring board below as shown in Figure 2. The apparatus is then moved in a horizontal direction, as shown in Figure 2, across the stencil 46.

During movement of the stencil, pressure source 2 acts on syringe 4 to force viscous material 100 from the syringe 4 into the interior chamber 66 of compression head 6 where it is diffused by diffuser 90 and directed to rectangular exit 68. The viscous material then enters volume 44 of compression headcap 8 which provides a contained environment via blades 78 and end caps 80 to direct the pressurised viscous material under pressure to the top surface of stencil 46. The viscous material is then extruded through openings 48 in the stencil 46 over which the compression headcap 8 travels. The extruded viscous material 100 is thereby printed on the printed wiring board 50. Movement of the compression headcap 8 across the stencil surface causes the trailing blade 78 which is angled inwardly relative to the interior chamber 66 to shear off the viscous material from the top surface of stencil 46. Once the apparatus has traversed the length of the stencil, the apparatus may simply reverse its direction and continue the compression printing process since the compression headcap 8 has dual blades 78 to accomplish the shearing process in either direction of movement.

Operating variables of the apparatus, such as run speed and pressure, may be adjusted to accommodate either viscous materials having a wide range of viscosities or stencils with holes having a wide range of diameters. The following data in Table 1 is representative of the parameters at which the apparatus has successfully operated. Print speed is measures in inches per second, air pressure is measured in pounds per square inch, viscosity of the solder paste is measured in centipoises per second, stencil apertures are measured in inches, and the particle sizes of the solder pastes used are between 10-37 microns.

**TABLE 1**

| Print Speed | | Air Pressure | Viscosity | | Aperture | |
|---|---|---|---|---|---|---|
| inches/sec. (cm/s) | | psi (Nm⁻²) | cps (10⁻³ Nsm⁻²) | | inches (cm) | |
| Low | High | | Low | High | Low | High |
| 0.94 (2.39) | 1.26 (3.20) | 20 (137896) | 850 K (850 K) | 1.0M (1.0 M) | 0.0055 (0.014) | >0.025 (0.0635) |
| 1.45 (3.67) | 1.70 (4.32) | 20 (137896) | 850 K (850 K) | 1.0M (1.0 M) | 0.0055 (0.014) | >0.025 (0.0635) |
| 2.27 (5.77) | 2.31 (5.87) | 20 (137896) | 850 K (850 K) | 1.0M (1.0 M) | 0.0055 (0.014) | >0.025 (0.0635) |
| 3.10 (7.87) | 3.89 (9.88) | 30 (206844) | 850 K (850 K) | 1.0M (1.0 M) | 0.0055 (0.014) | >0.025 (0.0635) |
| 4.20 (10.67) | 4.77 (12.12) | 30 (206844) | 850 K (850 K) | 1.0M (1.0 M) | 0.0055 (0.014) | >0.025 (0.0635) |
| 5.98 (15.19) | 6.62 (16.81) | 40-50 (275792-344740) | 850 K (850 K) | 1.0M (1.0 M) | 0.0075 (0.019) | >0.025 (0.0635) |
| 6.69 (16.99) | 7.23 (18.36) | 50-60 (344740-413688) | 850 K (850 K) | 1.0M (1.0 M) | 0.0075 (0.019) | >0.025 (0.0635) |
| 7.70 (19.56) | 8.00 (20.32) | 50-60 (344740-413688) | 850 K (850 K) | 1.0M (1.0 M) | 0.0075 (0.019) | >0.025 (0.0635) |

As indicated by the above data, the apparatus successfully operated over a wide range of print speeds, air pressures and stencil openings. The compression printing method disclosed herein advantageously provides for quicker print speeds, better quality of printing, and less waste of solder paste material than is encountered with conventional printing methods. A maximum print speed of 8 inches per second was achievable. It is noted, however, that for print speed in excess of 4.77 inches per second (12·12 cms/sec), increased air pressure was required in order to maintain acceptable print quality. This increased use of pressure produces two undesirable effects which was resolved in the second embodiment. These effects were: 1) Increases in pressure for improved print speeds caused an excessive back pressure to be imparted on the squeegee head. This back pressure lifted the non-compliant blades of the first embodiment above the surface of the stencil resulting in paste being left on the stencil. Excess pressures (above 60 psi) (41086 Nm⁻²) further lifted the head due to back pressure such that poor print depositions occurred. In essence, the process window for the first embodiment was significantly more narrow than that of the second embodiment. 2) Excessive pressures may exceed the tension force of the stencil. If this occurs, deformation of the stencil may result making it unusable. For this reason, the lowest air pressure is desirable.

### Second embodiment of the compression head

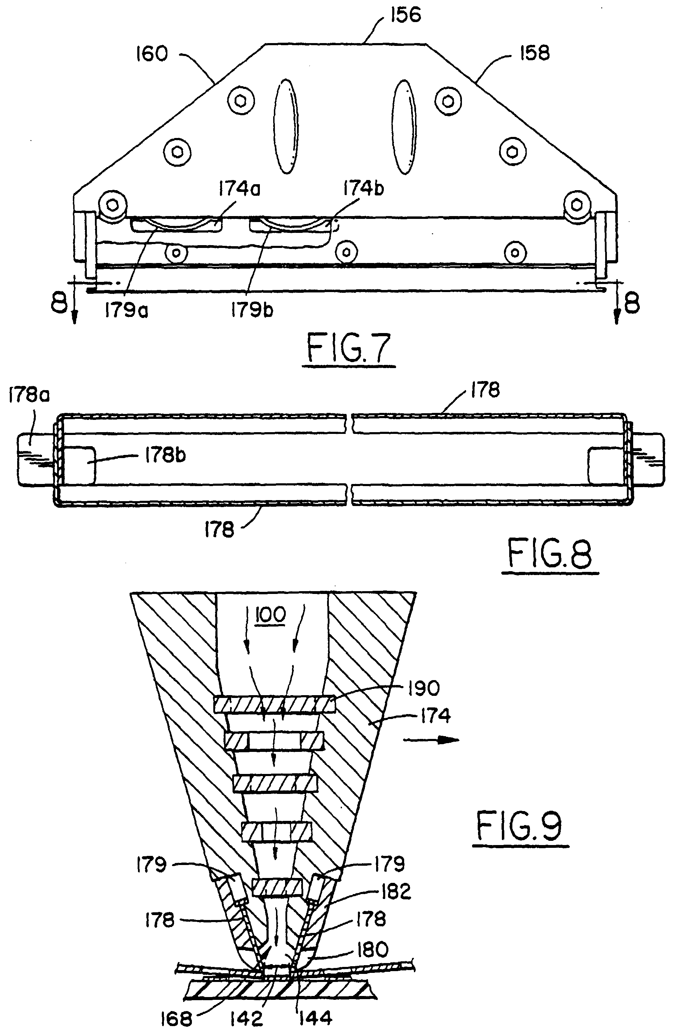

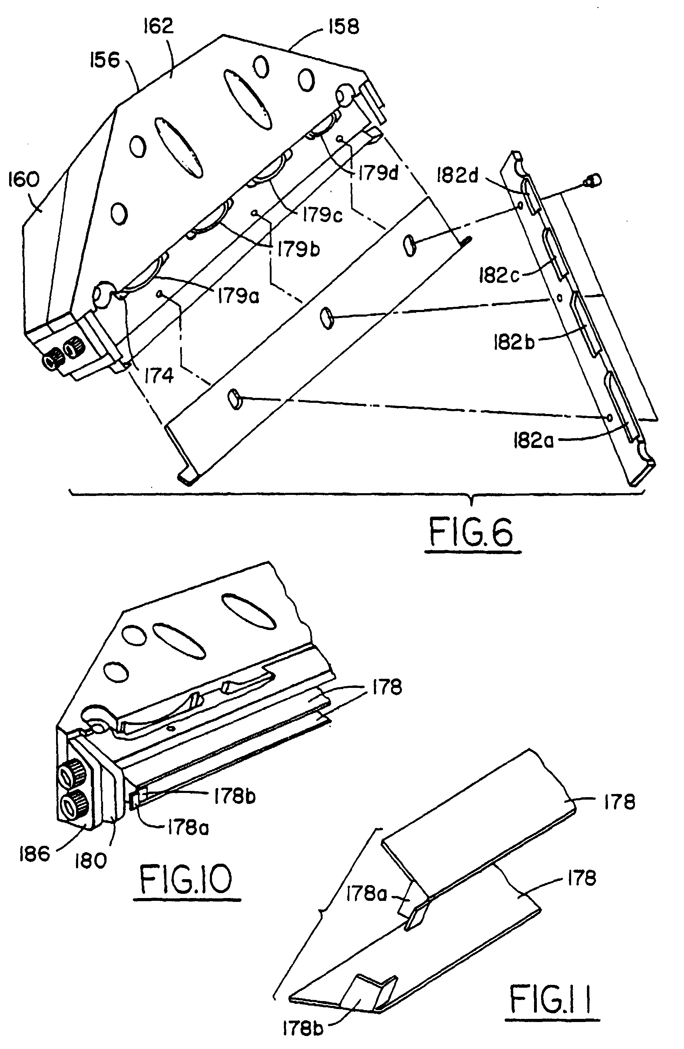

A second embodiment of the compression headcap will now be described with reference to Figures 6-11. Specific parts in the new compression headcap have been redesigned in order to provide higher through-put operation, more consistent coatings and reduced waste from the solder paste deposition process.

Except as specified hereafter, the second preferred embodiment of the compression head 106 includes the same parts as the original design for compression head 6. Parts having similar function will be defined by the same reference numerals as previously used in Figures 1-5, except that the new compression headcap design will have the reference numerals incremented by 100. As shown n Figures 6 and 9, the new compression head 106 contains corresponding elements such as the top surface 156, the side surfaces 158 and 160, the front and back surfaces 162 and 164 (hidden), and a tapered interior chamber 166 that terminates in a generally rectangular exit 168. The rectangular exit 168 opens into a tip volume 144 that is defined generally by the rectangular blades 178 on the sides, and the rectangular opening 142 at the bottom. As will be apparent from the subsequent explanation, the size of the rectangular opening 142 will vary depending upon the vertical displacement of the rectangular blades 178 as they ride across the stencil 46.

In order for the solder paste 100 to be uniformly deposited in the apertures 48 within the stencil 46 and onto the substrate 50 at a high speed, it is necessary for the rectangular wiper or squeegee blades 178 to maintain uniform spacing from the upper surface of the stencil 46 under all conditions. Experimental tests have shown that irregularities in the planar surface of the stencil 46, bending moments, slight irregularities in the substrate 50 and excessive back pressure of the solder paste 100 against the stencil 46 can cause gaps between the distended ends of the rectangular wiper blades 178 and the stencil 46 periodically during the process.

The effect produced by excessive back pressure of the solder paste 100 against the stencil 46 occurs at high speeds where the pressure of the pusher 34 within the syringe 4 must be increased to inject sufficient solder paste 100 so as to fill the apertures 48 within the stencil 46. When this pressure exerted on the solder paste 100 exceeds the pressure of the printhead and the rectangular squeegee blades 178 downwardly onto the stencil 46, then the resulting back pressure tends to lift the entire compression head 106 away from the stencil 46. Downward pressure on the compression head 106 cannot be increased further because this pressure may stretch the stencil 46 which may be permanently deformed. This lifting of the compression head 106 also can cause leakage of the solder paste 100 and loss of contact between the rectangular squeegee blades and the stencil.

The second preferred embodiment of the compression head 106 addresses this operational problem by providing a series of leaf springs 179a, b, c, and d which are more clearly illustrated in Figures 6, 7 and 9. With specific reference to Figure 6, the leaf spring 179a is contained within a channel formed by a first half 174a in the bottom side section 174 of the compression head 106 and another similar channel 182a in the rectangular blade holder 182. As illustrated in Figures 6 and 9, the upper edge of the rectangular blade 178 rests upon and compresses the four leaf springs 179a, b, c and d. The compression force serves to bias the rectangular wiper blade 178 into close communication with the stencil 46. In this manner, if a portion of the stencil is not flat or in some other manner is deformed, the biasing force produced by the leaf springs 179a, b, c and d will cause the distended edge of the rectangular wiper blades 178 to closely track the upper surface of the stencil 46, notwithstanding such surface defect. Furthermore, the downward pressure on the compression head 106 now may be increased to overcome the back pressure exerted by the solder paste 100 without damaging the stencil. The additional down pressure on the compression head 106 is compensated by the biasing forces of the springs 179 as they allow the compression head 106 to "float" over the stencil 46 without losing contact as before. Thus, higher relative printing speeds may be maintained with improved quality levels, such as reduced bridging between adjacent but separated deposits of solder paste.

This close tracking of the upper surface of the stencil 46 by the distended end of the rectangular blade 178 allows the speed of the process to be increased substantially while at the same time improving the quality and consistency of the solder paste 100 deposited within the apertures 48 inside the stencil 46. For example, the conventional dual squeegee method for depositing the solder paste into apertures 48 within the stencil 46 operates at a linear speed of only about 2 inches per second (5.08 cms/sec), and in a production mode produces typical defects on the order of 480-485 parts per million. The compression head 6 illustrated in Figures 1, 2, 3 and 4 operates at a faster 3-4 inches per second (7.62-10.16 cms/sec), and yet products typical defects on the order of 95-100 parts per million. The improved compression head 106 as illustrated in Figures 6 through 11 is capable of operating at a linear speed of 6 inches per second (15.24 cms/sec) (or greater), and yet produces typical defects on the order of only 11 parts per million. This increase in speed and quality levels results, at least in part, from a reduction in pressure on the compression head 106 to less than 12 pounds (29 to 30 pounds per square inch (19858-20543 Nm⁻²) for two blades over the maximum range of travel (0.090"/(0.23 cms)) as compared to 25-30 pounds (11.34-13.61 Kgs) for the compression head 6 and more than 30 pounds (13.61 Kgs) pressure for prior art devices.

When translated into throughput capabilities (as measured by test boards per hour, with zero bridging defects), the improved compression head 106 is capable of approximately 240 test boards per hour as compared to approximately 150 boards per hour for the compression head 6 and only about 90 boards per hour for the prior art flexible blade devices. The improvements in deposition uniformity (as defined by the standard deviation of the weight of solder deposited per area) is improved over the baseline provided by the flexible blade devices of the prior art by about 102% for the compression head 6 and by about 114% for the compression head 106. Estimated wasted solder paste per 300 gram syringe is reduced from approximately 75-100 grams for the flexible blade devices of the prior art, to approximately 50-75 grams for the compression head 6, and to only about 25 grams or less for the improved compression head 106.

These productivity and quality improvements are achieved even though the improved compression head 106 system is less expensive to manufacture because no complex equipment or processing is required to level the printhead prior to the printing process.

While the preferred embodiment of the improved compression head 106 utilises leaf springs, it will be apparent that coiled springs or other similar mechanisms capable of providing a biasing force on the upper end of the rectangular blades 178 may also be used. While mechanical springs have been illustrated, the biasing force could also be exerted through hydraulic, pneumatic, hydrostatic or other similar means. The leaf springs 178 are manufactured from 0.010 inch (0.0254 cm) thick spring steel that is approximately 0.1 inches (0.254 cm) to 0.25 inches (0.64 cm) in width. The shape and construction of the leaf springs 179a, b, c and d provide a biasing force of approximately 10 pounds (4.5 Kg) to 12 pounds (5.4 Kg) of pressure exerted upon the upper edge of the rectangular blade 178 for forcing the lower distended edge thereof into sliding communication with the stencil 46. For 0.040"-0.045" (0.10cm-0.11cm) deflection (the normal operating range) to 0.090" (0.23 cm) (maximum deflection), the biasing force measured approximately 10.9 psi (74639 Nm⁻²). The direction of the biasing force is generally parallel to the plane of the rectangular wiper blade 178 to force it into closer communication with the stencil 46. It will be apparent to one skilled in the art that these materials, measurements and pressures are listed as examples, and this embodiment could be easily adapt for enlarging the size of the compression head 106, increasing the speed of movement, etc.

It should be apparent from Figure 9 and the above description that as the rectangular wiper blades 178 cause a vertical movement and compression of the leaf springs 179a, b, c and d, the width of the rectangular opening 144 will vary. When both the leading and trailing rectangular wiper blades 178 are displaced in the vertical direction to compress the leaf springs 179, the rectangular opening 142 will increase slightly in width.

As illustrated in Figures 8, 10 and 11, cooperating integral end caps 178a and 178b are located at the longitudinal ends of the rectangular blades 178 adjacent the end cap 180. The cooperating integral end caps 178a and 178b have vertically oriented sections that slidingly overlap each other as the width of the rectangular opening 142 changes. Therefore, the viscous material 100 will be held within the tip volume 144 by the overlapping surface produced by the cooperating integral end caps 178a and 178b, in cooperation with the end cap 180 and the end cap mounts 186.

The cooperating integral end caps 178a and 178b also include horizontally disposed pads that, while not overlapping, provide additional sealing impediments to the flow of the viscous material 100 from the ends of the rectangular opening 184. During operation, the cooperating integral end caps 178a and 178b substantially eliminate mounds of viscous material that can appear at the longitudinal ends of the compression head 106. By eliminating these wasteful mounds, the expensive viscous material can be conserved and additional cleaning steps for the substrates and the stencil are not required.

Except for the above described mechanical changes in the second preferred embodiment of the compression head 106 and cap 108, the remainder of the method and apparatus for dispensing viscous material operates in according with the first preferred embodiment of the invention.

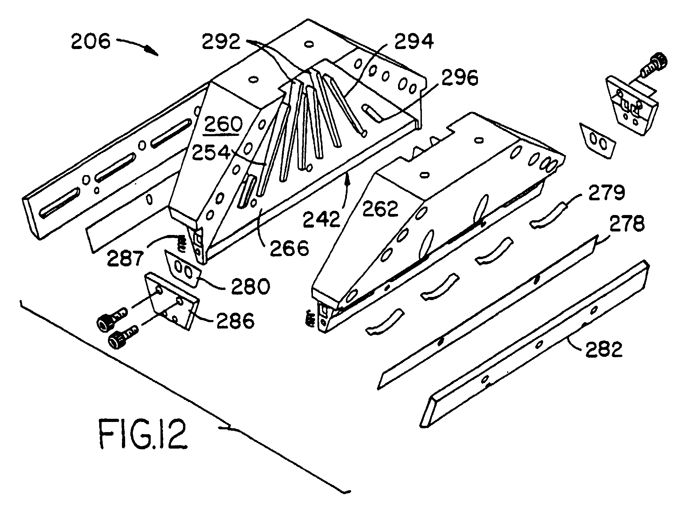

With reference to Figure 12, a third preferred embodiment of the compression head 206 is illustrated as including a plurality of diffuser plates 290 that are vertically disposed within the interior chamber 266. The plurality of diffuser plates 290 include two major diffuser plates 292 and four minor diffuser plates 294. Two subminor diffuser plates 296 are also included adjacent the lower portion of the interior chamber 266. These diffuser plates 290 serve to break up and redistribute the flow of the viscous material in order to evenly and uniformly present the material from side to side across the rectangular exit 242, while also serving to equalise the pressure of the viscous material flowing out of the rectangular opening 242.

The length, angular separation and relative separation between the plurality of diffuser plates 290 have been designed to provide the optimum balance between breaking up the flow of the viscous material and evenly distributing it throughout the entire cross section of the rectangular exit 242.

It should be apparent from Figure 12 that both the left section 260 and the right section 262 of the compression head 206 include a plurality of diffuser plates 290. In this embodiment, the major diffuser plates 292 in the visible left section 260 align precisely with corresponding major diffusion plates 292 in the hidden half of the right section 262 of the compression head 206. In a similar manner, the minor diffusion plates 294 and the subminor diffusion plates 296 align with corresponding diffuser plates in the hidden right section 262 of the compression head 206. Under certain conditions it may be desirable to utilise diffuser plates of different lengths, different orientations and different non-corresponding alignments in the two sections of the compression head 206 in order to provide additional mixing and to improve the uniformity of the viscous material as required by the specific application.

The vertical diffusion plates 290 are canted from the vertical direction by approximate angles of 6.5° for the first minor diffusion plate 294 closest to the centreline, 19.5° for the major diffusion plate 292, 33.5° for the second minor diffusion plate 294, and 44.5° for the subminor diffusion plate 296.

The vertical channel design uses optimised streamwise vanes to guide the paste flow through the divergent compression printing head. The spread angles between diffuser plates 290 and the length of individual diffuser plates are analytically determined through computational fluid dynamics (CFD) technique so that the viscous material distributes evenly at the exit of the printing head.

The new design results in a pressure drop reduction of about 21 pounds per square inch (144791 Nm⁻²) (from 91 to 70 pounds per square inch (627427 to 482636 Nm⁻²) to deliver the same volume of viscous material flow rate when compared with the previous design shown in Figures 1 through 5. Moreover, the undesired wakes behind the blockages of the old design are completely eliminated. This results in a uniform flow distribution at the head exit.

The diffuser plates 290 equalise the velocity distribution of the viscous material at the exit and improve the pressure recovery. Since the divergent angle of the compression head is very large, it always gives rise to an undesired "stalled" condition in the diffuser. Instead of a uniform velocity distribution of the viscous material, the flow may form a jet-like pattern throughout the diffuser. The vertical channels subdivide the single large divergent passage into several smaller channels with much smaller opening angles to eliminate the flow stall. The velocity of the viscous material is always higher in the central region than that in the vicinity of the walls. It is essential that the geometrical configuration of the diffuser plates guide appropriate viscous material flow rates into each individual channel such that a uniform velocity distribution is attained at the exit. Consequently, channel width is relatively narrower near the centre and wider near the extremities. Moreover, for the passage away from the centreline, the divergent angle is not symmetric. This will create a biased flow of the viscous material toward the centre. Two subminor diffuser plates 296 are located near the exit of the two sidewall channels to correct this undesired effect. The vertical channels defined by the diffuser plates 290 result in a reduction of the back pressure of about 24% on the flow of the viscous fluid 100 through the compression head 206.

## Claims

1. An apparatus for compressing a viscous material through openings in a stencil (46), comprising:
a reservoir (4) containing a supply of the viscous material;
a pressure source (2) operably connected to the reservoir (4) whereby pressure is applied to the supply of viscous material;
a housing (6) having a first opening (40) in fluid communication with the reservoir (4) and a substantially uniform second opening (42) defined by a compression headcap (8) formed from contiguous walls, the compression headcap (8) having a pair of substantially parallel wiping blades (78), and
means for biasing said wiping blades (178) into sliding communication over the stencil;
characterised in that a diffuser (90) is provided within the interior (66) of housing (6) between the first opening (40) and the second opening (42).

2. An apparatus as claimed in claim 1 further characterised in that the diffuser (90) comprises a plurality of diffuser plates (92) which are horizontally disposed within interior (66) of the housing (6), each of said diffuser plates (92) having a series of openings (96) through which the viscous material is to flow.

3. An apparatus as claimed in claim 2 further characterised in that each opening (96) decreases in average size as the diffuser plates (92) progress from the first opening (40) to the second opening (42).

4. An apparatus as claimed in claim 1 further characterised in that the diffuser (90) comprises a plurality of diffuser islands (98) which are horizontally disposed in rows within the interior (66) of the housing (6).

5. An apparatus as claimed in claim 4 further characterised in that the diffuser islands (98) are fixedly installed within the housing (6).

6. An apparatus as claimed in claim 4 further characterised in that the diffuser islands (98) are moulded directly within the interior (66) of housing (6).

7. An apparatus as claimed in any one of claims 4 to 6 further characterised in that the diffuser islands (98) increase in number as the rows progress from the first opening (40) to the second opening (42).

8. An apparatus as claimed in any one of the preceding claims, wherein said second opening (42) is formed from said pair of wiping blades (78) arranged to define a V-shaped opening of variable size.

9. An apparatus as claimed in claim 8 wherein the size of said second opening (42) changes as said pair of wiping blades (78) are displaced against said biasing means.

10. An apparatus as claimed in claim 8 wherein opposing ends of said parallel blades including juxtaposed integral caps for slidingly engaging each other to seal end sections of said second opening.

11. An apparatus as claimed in claim any one of the preceding claims, wherein said biasing means comprise springs operatively interposed between said wiping blades (78) and said housing (6).

12. An apparatus as claimed in claim 11, wherein said springs comprise leaf springs (179a,179b,179c,179d).

13. An apparatus as claimed in either claim 11 or claim 12, wherein said springs exert a biasing force generally parallel to the plane of a wiping blade (78).

14. An apparatus as claimed in any one of the preceding claims, wherein said housing is progressively tapered in width from said first opening (40) to said compression headcap (8).

15. An apparatus as claimed in any one of the preceding claims in which the wiping blades are made of a rigid material.

## Patentansprüche

1. Vorrichtung zum Auspressen von viskosem Material durch Öffnungen in einer Schablone (46), folgendes aufweisend:
einen Vorratsbehälter (4) mit einem Vorrat des viskosen Materials;
eine Druckquelle (2), welche betriebsmäßig mit dem Vorratsbehälter verbunden ist, und durch welche Druck auf den Vorrat an viskosem Material ausgeübt wird;
ein Gehäuse (6) mit einer ersten Öffnung (40) in Flußverbindung mit dem Vorratsbehälter (4) und einer im wesentlichen gleichförmigen zweiten Öffnung (42), welche von einem Preßkopf (8) gebildet wird, der von sich berührenden Wänden gebildet wird, wobei der Preßkopf (8) zwei im wesentlichen parallele Streichrakel (78) aufweist, und
Mittel zum Vorspannen der besagten Streichrakel (178) in gleitende Anlage an besagte Schablone;
dadurch gekennzeichnet, daß ein Verteiler (90) im Innern (66) des Gehäuses (6) zwischen der ersten Öffnung (40) und der zweiten Öffnung (42) angeordnet ist.

2. Vorrichtung nach Anspruch 1, weiterhin dadurch gekennzeichnet, daß der Verteiler (90) mehrere Verteilerplatten (92) aufweist, welche horizontal im Innern (66) des Gehäuses (6) angeordnet sind, wobei jede der Verteilerplatten (92) eine Reihe von Öffnungen (96) aufweist, durch welche das viskose Material fließen muß.

3. Vorrichtung nach Anspruch 2, weiterhin dadurch gekennzeichnet, daß jede Öffnung (96) in ihrer Durchschnittsgröße abnimmt, je weiter sich die Verteilerplatten (92) von der ersten Öffnung (40) her der zweiten Öffnung (42) nähern.

4. Vorrichtung nach Anspruch 1, weiterhin dadurch gekennzeichnet, daß der Verteiler (90) mehrere Verteilerinseln (98) aufweist, welche horizontal in Reihen im Innern (66) des Gehäuses (6) angeordnet sind.

5. Vorrichtung nach Anspruch 4, weiterhin dadurch gekennzeichnet, daß die Verteilerinseln (98) fest im Gehäuse (6) eingebaut sind.

6. Vorrichtung nach Anspruch 4, weiterhin dadurch gekennzeichnet, daß die Verteilerinseln (98) direkt im Innern (66) des Gehäuses (6) eingeformt sind.

7. Vorrichtung nach einem beliebigen der Ansprüche 4 bis 6, dadurch gekennzeichnet, daß die Zahl der Verteilerinseln (98) um so größer wird, je weiter sich die Reihen von der ersten Öffnung (40) her der zweiten Öffnung (42) nähern.

8. Vorrichtung nach einem beliebigen der vorangehenden Ansprüche, worin besagte zweite Öffnung (42) mit einem Streichrakelpaar (78) ausgebildet ist, das so angeordnet ist, daß es eine V-förmige Öffnung variabler Größe bildet.

9. Vorrichtung nach Anspruch 8, in welcher sich die Größe der besagten zweiten Öffnung (42) ändert, wenn besagtes Streichrakelpaar (78) entgegen besagter Vorspannvorrichtung bewegt wird.

10. Vorrichtung nach Anspruch 8, worin gegenüberliegende Enden der besagten parallelen Streichrakel angeformte gegenüberliegende Kappen aufweisen, die gleitend miteinander in Eingriff treten, so daß sie die Endabschnitte der besagten zweiten Öffnung abdichten.

11. Vorrichtung nach einem beliebigen der vorangehenden Ansprüche, worin besagte Vorspannmittel Federn beinhalten, welche funktionsmäßig zwischen besagten Streichrakeln (78) und besagtem Gehäuse (6) angeordnet sind.

12. Vorrichtung nach Anspruch 11, worin besagte Federn Blattfedern (179a, 179b, 179c, 179d) beinhalten.

13. Vorrichtung nach Anspruch 11 oder Anspruch 12, worin besagte Federn eine Vorspannkraft ausüben, welche allgemein parallel zur Ebene eines Streichrakels (78) verläuft.

14. Vorrichtung nach einem beliebigen der vorangehenden Ansprüche, worin sich besagtes Gehäuse in seiner Form allmählich von besagter erster Öffnung (40) zu besagtem Preßkopf (8) hin verjüngt.

15. Vorrichtung nach einem beliebigen der vorangehenden Ansprüche, worin die Streichrakel aus einem steifen Werkstoff hergestellt sind.

## Revendications

1. Dispositif destiné à comprimer un matériau visqueux au travers d'ouvertures dans un stencil (46), comprenant :
un réservoir (4) contenant une réserve du matériau visqueux,
une source de pression (2) raccordée de façon fonctionnelle au réservoir (4), grâce à laquelle une pression est appliquée à la réserve de matériau visqueux,
un logement (6) comportant une première ouverture (40) en communication de fluide avec le réservoir (4) et une seconde ouverture pratiquement uniforme (42) définie par une coiffe de tête de compression (8) formée à partir de parois contiguës, la coiffe de tête de compression (8) comportant une paire de lames d'essuyage pratiquement parallèles (78), et
un moyen destiné à solliciter lesdites lames d'essuyage (178) en contact glissant sur le stencil,
caractérisé en ce qu'un diffuseur (90) est prévu dans l'intérieur (66) du logement (6) entre la première ouverture (40) et la seconde ouverture (42).

2. Dispositif selon la revendication 1, caractérisé en outre en ce que le diffuseur (90) comprend une pluralité de plaques de diffuseur (92) qui sont disposées horizontalement dans l'intérieur (66) du logement (6), chacune desdites plaques de diffuseur (92) comportant une série d'ouvertures (96) au travers desquelles le matériau visqueux doit s'écouler.

3. Dispositif selon la revendication 2, caractérisé en outre en ce que chaque ouverture (96) diminue en taille moyenne à mesure que les plaques du diffuseur (92) progressent de la première ouverture (40) vers la seconde ouverture (42).

4. Dispositif selon la revendication 1 caractérisé en outre en ce que le diffuseur (90) comprend une pluralité d'îlots (98) de diffuseur qui sont disposés horizontalement en rangées dans l'intérieur (66) du logement (6).

5. Dispositif selon la revendication 4, caractérisé en outre en ce que les îlots de diffuseur (98) sont installés de façon fixe à l'intérieur du logement (6).

6. Dispositif selon la revendication 4, caractérisé en outre en ce que les îlots de diffuseur (98) sont moulés directement dans l'intérieur (66) du logement (6).

7. Dispositif selon l'une quelconque des revendications 4 à 6 caractérisé en outre en ce que les îlots de diffuseur (98) augmentent en nombre à mesure que les rangées progressent depuis la première ouverture (40) vers la seconde ouverture (42).

8. Dispositif selon l'une quelconque des revendications précédentes, dans lequel ladite seconde ouverture (42) est formée à partir de ladite paire de lames d'essuyage (78) agencées pour définir une ouverture en forme de V de taille variable.

9. Dispositif selon la revendication 8, dans lequel la taille de ladite seconde ouverture (42) varie à mesure que les lames de ladite paire de lames d'essuyage (78) sont déplacées en s'opposant audit moyen de sollicitation.

10. Dispositif selon la revendication 8, dans lequel des extrémités opposées desdites lames parallèles comprennent des bouchons solidaires juxtaposés destinés à venir en prise mutuelle par coulissement afin de fermer hermétiquement les sections d'extrémité de ladite seconde ouverture.

11. Dispositif selon l'une quelconque des revendications précédentes, dans lequel ledit moyen de sollicitation comprend des ressorts intercalés de façon fonctionnelle entre lesdites lames d'essuyage (78) et ledit logement (6).

12. Dispositif selon la revendication 11, dans lequel lesdits ressorts comprennent des ressorts à lames (179a, 179b, 179c, 179d).

13. Dispositif selon l'une ou l'autre de la revendication 11 ou de la revendication 12, dans lequel lesdits ressorts exercent une force de sollicitation sensiblement parallèle au plan d'une lame d'essuyage (78).

14. Dispositif selon l'une quelconque des revendications précédentes, dans lequel ledit logement est progressivement effilé en largeur depuis ladite première ouverture (40) vers ladite coiffe de tête de compression (8).

15. Dispositif selon l'une quelconque des revendications précédentes, dans lequel les lames d'essuyage sont faites d'un matériau rigide.
